# EUROPEAN PATENT APPLICATION

(11) **EP 4 531 096 A1**
(43) Date of publication of application: **02.04.2025**
(21) Application number: 23825870.1
(22) Date of filing: 27.03.2023
(51) Int. Cl.: H01L 23/367

(54) **POWER MODULE AND MANUFACTURING METHOD THEREFOR**

(30) Priority: 24.06.2022 CN 202210730145
(71) Applicant: Huawei Digital Power Technologies Co., Ltd., Shenzhen, Guangdong 518043 (CN)
(72) Inventor: CHEN, Huibin, Shenzhen, Guangdong 518043 (CN); LI, Jiyang, Shenzhen, Guangdong 518043 (CN); WANG, Heng, Shenzhen, Guangdong 518043 (CN)
(74) Representative: Gill Jennings & Every LLP
(86) International application number: PCT/CN2023/083991
(87) International publication number: WO 2023/246214

(57) **Abstract**

This application provides a power module and a manufacturing method therefor, a motor driver, a powertrain, and a vehicle. The power module includes a first substrate, a second substrate, a first heat sink, a second heat sink, and a chip that are disposed opposite to each other. The chip is disposed between the first heat sink and the second heat sink that are disposed opposite to each other. The first heat sink and the second heat sink are connected to the chip through sintering or welding. The first substrate and the second substrate are respectively connected to the first heat sink and the second heat sink through welding or sintering. The first heat sink and the second heat sink have high heat conductivity and high electrical conductivity, and heat from the chip is quickly and evenly conducted to the first substrate and the second substrate. This helps decrease a transient and steady-state temperature of the chip. In a same chip size, more currents can pass through, and power density of the chip is effectively improved.

## Description

### TECHNICAL FIELD

This application relates to the field of electronic and electric power technologies, and in particular, to a power module and a manufacturing method therefor, a motor driver, a powertrain, and a vehicle.

### BACKGROUND

In recent years, green energy has developed increasingly, and gradually becomes a main means for resolving an energy crisis. As a typical application of the green energy, an electric vehicle has been booming, and a market demand for in-vehicle motor drive apparatuses increases annually. As a core component for power conversion, a power module has attracted more attention. In addition, for a purpose of energy saving and environmental protection, and a purpose of obtaining a longer driving mileage of a battery-powered electric vehicle, the power module is required to have higher electric energy conversion efficiency. For a requirement of energy saving and low costs, the power module is urgently required to be lighter and miniaturized. However, the requirement brings a great challenge to development of the power module. Because lightness and miniaturization cause an increase in current density of the module, high heat is generated inside the module, resulting in an increase in a junction temperature. If the generated heat cannot be dissipated in time, the high junction temperature affects overall thermal mechanical performance and reliability of the power module.

### SUMMARY

This application provides a power module and a manufacturing method therefor, a motor driver, a powertrain, and a vehicle. A chip is disposed between heat sinks with high conductivity and heat conductivity, and the chip is connected to the heat sink through a high conductivity connection (sintering or diffusion welding), to form a new fast cooling structure. In addition, two sides of the new fast cooling structure are connected to substrates to form a power module. When the chip in a working state generates a power loss due to quick conduction and disconnection, which causes a temperature rise of the chip, the high heat conductivity connection quickly conducts heat of the chip into a heat sink structure, to control the temperature rise of the chip and decrease a transient temperature of the chip. In addition, because a high conduction heat sink with high heat conductivity has good heat conduction effect and good temperature uniformity effect, heat from the chip is rapidly equalized and conducted to the substrate, so that an equivalent conduction size is expanded. In addition, a size of a heat sink connected to an unwired surface of the chip is greater than a size of the chip, thereby further improving uniform diffusion effect and decreasing a temperature of the chip in a steady state. Because a transient temperature and a steady state temperature of the chip decrease, the chip can withstand a larger current in a same size, thereby effectively increasing power density of the chip.

Therefore, the following technical solutions are used in embodiments of this application.

According to a first aspect, an embodiment of this application provides a power module. The power module includes a first substrate, a second substrate, a first heat sink, a second heat sink, and a chip. The chip is disposed between the first heat sink and the second heat sink that are disposed opposite to each other. The chip and the first heat sink are connected by using a high heat conductive material through sintering, and the high heat conductive material is used to quickly conduct heat generated by the chip in a working state to the first heat sink. The chip is connected to the second heat sink by using a high heat conductive material through sintering or by using a common soft brazing material through welding. The first heat sink and the second heat sink have high heat conductivity, and can quickly conduct heat from the chip, thereby decreasing a transient temperature. In addition, the first heat sink and the second heat sink have good temperature uniformity performance, which can expand a heat dissipation size, decrease a local temperature, and improve a heat dissipation feature. The first substrate is connected to the first heat sink through welding or sintering, and the second substrate is connected to the second heat sink through welding or sintering. The first substrate and the second substrate have heat dissipation sizes greater than those of the first heat sink and the second heat sink, respectively conduct heat from the first heat sink and the second heat sink to another heat dissipation apparatus such as a heat dissipater, thereby decreasing a temperature of the chip in a steady state. The power module in the present invention can effectively decrease the temperature of the chip in the transient state and the steady state, so that the chip can bear a large current in a same size, thereby improving power density of the chip.

With reference to the first aspect, in a first possible implementation, the chip is disposed between the first heat sink and the second heat sink that are disposed opposite to each other. A connection surface between the chip and the first heat sink is a first connection surface of the chip. The chip is connected to the first heat sink by using a first material, and the first material has high heat conductivity. The first material includes but is not limited to silver paste, copper paste, silver film, and the like. The first material connects the chip to the first heat sink through high temperature sintering or diffusion welding, and a thickness of the first material is 5 µm to 50 µm. In addition, the first material further has a high electrical conductivity feature, and provides a transmission channel for current flow of the chip inside the power module. Because a first connection surface of the chip has no pin, and does not need to perform an operation such as wiring, the first connection surface of the chip may be in full contact with the first heat sink. In addition, to fully use a temperature uniformity feature of the first heat sink, generally, a size of a surface that is of the first heat sink and that is close to the chip is greater than or equal to a size of the first connection surface of the chip. It may be understood that the first material has high heat conductivity, and can quickly conduct heat generated during working of the chip to the heat sink, thereby effectively decreasing the transient temperature of the chip, and preventing the chip from being burnt due to an excessively high temperature in a short time. In addition, the size of the first heat sink is greater than or equal to the size of the chip, and the heat sink has good temperature uniformity effect. This effectively decreases a steady state temperature of the chip, and decreases heat generated when the chip works for a long time. Therefore, in a same chip size, the chip can bear a higher current, thereby improving power density of the chip.

With reference to the first aspect, in a second possible implementation, the chip is disposed between the first heat sink and the second heat sink that are disposed opposite to each other. A connection surface between the chip and the second heat sink is a second connection surface of the chip. The chip is connected to the second heat sink by using a second material, and the second material is a soft brazing material. The second material includes but is not limited to Sn3.5Ag 0.5Cu, SnSb5, SnSb10, High Pb, AuSn, and the like. The second material connects the chip to the second heat sink through welding. The second connection surface of the chip has a pin. Therefore, a size of the second connection surface is less than a size of the chip. It may be understood that, with reference to the first possible implementation of the first aspect, the heat sinks are located on both upper and lower sides of the chip to take away heat of the chip, so that a heat dissipation size of the chip can be fully used, heat dissipation efficiency can be improved, and power density of the chip can be improved. In addition, the upper and lower heat sinks are designed to balance the thermal stress mismatch to a maximum extent and decrease structural stress received by the chip. The heat sinks are used as buffer protection on both sides of the chip, to prolong a working life of the component, and further improve reliability of the chip.

With reference to the first aspect, in a third possible implementation, the chip is disposed between the first heat sink and the second heat sink that are disposed opposite to each other. The chip may also be connected to the first heat sink by using the second material, that is, the chip may be connected to the first heat sink by using a common soft brazing material through welding. Similarly, the chip may also be connected to the second heat sink by using the first material, that is, the chip may be connected to the second heat sink by using a high heat conductive material through sintering. Further, the chip may be connected to the first heat sink and the second heat sink by using the first material, that is, the chip is connected to the first heat sink by using the high heat conductive material through sintering, or the chip is connected to the first heat sink and the second heat sink by using the soft brazing material through welding. Alternatively, the chip is connected to the first heat sink and the second heat sink by using the first material and the second material that are mixed used. A specific use solution may be designed based on a specific application scenario. It may be understood that a connection manner between the chip, the first heat sink, and the second heat sink is flexible and has strong applicability.

With reference to the first aspect, in a fourth possible implementation, the first heat sink and the second heat sink in the power module have high heat conductivity and high electrical conductivity. The high heat conductivity feature may transfer heat generated by the chip during working to the heat sink, and the high electrical conductivity feature may meet a requirement of internal current flow of the chip during working, and provide a channel for internal current flow. Materials of the first heat sink and the second heat sink include but are not limited to a material having high heat conductivity, such as Cu, a CuMo composite material, diamond, a diamond-copper composite material, and an Al-SiC composite material. It may be understood that, the first heat sink and the second heat sink include a material having high heat conductivity and high electrical conductivity, so that heat dissipation performance of the chip can be improved, and a current channel can be provided for the chip. This improves heat dissipation performance of the power module, and further improving power density of the power module.

With reference to the first aspect, in a fifth possible implementation, the first substrate and the second substrate are disposed opposite to each other, the first substrate is disposed on a surface that is of the first heat sink and that is away from the chip, and the second substrate is disposed on a surface that is of the second heat sink and that is away from the chip. The first substrate is connected to the first heat sink by using the second material, and the second substrate is connected to the second heat sink by using the second material, that is, through welding by using the soft brazing material. Similarly, to improve heat dissipation performance of the power module, the first substrate may be connected to the first heat sink by using the first material, and the second substrate may be connected to the second heat sink by using the first material, that is, by using the high heat conductive material through sintering.

With reference to the first aspect, in a sixth possible implementation, the power module includes a first substrate and a second substrate, and the first substrate and the second substrate include a first conductive layer, a second conductive layer, and a first insulation layer located between the first conductive layer and the second conductive layer. The first substrate is connected to a surface that is of the first heat sink and that is away from the chip, and a surface that is of the first substrate and that is in contact with the first heat sink is the first conductive layer of the first substrate. The second substrate is connected to a surface that is of the second heat sink and that is away from the chip, and a surface that is of the second substrate and that is in contact with the second heat sink is the first conductive layer of the second substrate. A material of the first conductive layer of the first substrate and the second substrate is Cu, Al, or the like, and the first conductive layer is configured to provide a channel for flow of a current inside the chip. A material of the first insulation layer of the first substrate and the second substrate is an insulation material such as ceramic, and the first insulation layer is configured to prevent the first conductive layer of the first substrate and the second substrate from being conducted with a heat dissipater. A material of the second conductive layer of the first substrate and the second substrate is Cu, Al, and the like, and the second conductive layer is configured to protect the first insulation layer in the first substrate and the second substrate, to prevent the first insulation layer from breaking. In addition, the second conductive layer has a heat conduction function, and conducts heat from the first insulation layer to a heat dissipaterin contact with the second conductive layer.

Generally, the first substrate and the second substrate may be a direct bond copper (DBC), an active metal brazed copper substrate (AMB, for example, Al2O3-AMB, Si3N4-AMB, or AlN-AMB), an insulated metal substrate (IMS), or the like. This is not limited herein. For example, to further improve power density, the first substrate and the second substrate may be formed by using AlN-DBC, Si3N4-AMB, or AlN-AMB with high heat conductivity. This is not limited herein.

With reference to the first aspect, in a seventh possible implementation, the connection surface between the chip and the second heat sink is the second connection surface of the chip, the second connection surface of the chip has a pad, the pad is embedded into the chip, a surface that is of the pad and that is not embedded into the chip is flush with the second connection surface of the chip, and the pad is connected to the second heat sink by using the first material or the second material. It may be understood that the surface that is of the pad and that is not embedded into the chip is flush with the second connection surface of the chip, so that the chip is in full contact with the second heat sink, thereby improving heat dissipation efficiency, and reducing stress between the chip and the second heat sink. In this case, stress on the contact surface is uniform, thereby helping protect the power module from being damaged.

With reference to the first aspect, in an eighth possible implementation, the chip includes a power semiconductor chip such as an insulated gate bipolar transistor chip, an insulated gate bipolar transistor chip and a diode chip packaged chip, a silicon metal-oxide-semiconductor field-effect transistor, a silicon carbide metal-oxide-semiconductor field-effect transistor, or a gallium nitride metal-oxide-semiconductor field-effect transistor.

With reference to the first aspect, in a ninth possible implementation, the chip includes at least two independent chips, and the at least two independent chips are disposed between the first heat sink and the second heat sink, that is, the at least two independent chips share a same first heat sink and a same second heat sink. Similarly, the at least two independent chips are respectively disposed between first heat sinks and second heat sinks corresponding to the at least two independent chips, the first heat sinks corresponding to the at least two independent chips are independent of each other and are not directly connected to each other, and the second heat sinks corresponding to the at least two independent chips are independent of each other and are not connected to each other. When the chip includes the at least two independent chips, a manner of connecting the independent chips to the first heat sink and the second heat sink is not limited in embodiments of the present invention.

With reference to the first aspect, in a tenth possible implementation, the power module further includes a terminal, one end of the terminal is electrically connected to the chip, the other end of the terminal is located outside the power module, and the terminal is configured to connect the chip in the power module to an external circuit. The power module further includes a binding line, one end of the binding line is electrically connected to the chip, and the other end of the binding line is electrically connected to the signal terminal, so that the chip is conductive to the signal terminal. It may be understood that the signal terminal is used for the chip to communicate with an external signal.

With reference to the first aspect, in an eleventh possible implementation, the power module further includes a molding body. The first substrate, the second substrate, the first heat sink, the second heat sink, and the chip are disposed in the molding body, and the first substrate, the second substrate, the first heat sink, the second heat sink, and the chip are fastened and sealed by using the molding body, to form a power semiconductor package. In addition, at least a part of an area that is of the molding body and that is opposite to at least one of the first substrate and the second substrate is an exposed area. In this way, blocking of a molding layer is eliminated, and the first substrate is in closer contact with the second substrate and the heat dissipater, thereby facilitating heat transfer. It may be understood that the molding body seals the power module, prevents external water and gas from entering the power module, and prevents a short circuit phenomenon of the power module. In addition, the molding body fastens each part of the power module, thereby improving stability between the parts of the power module.

With reference to the first aspect, in a twelfth possible implementation, the power module further includes a first heat dissipater and a second heat dissipater. The first heat dissipater and the second heat dissipater are disposed opposite to each other, and the first substrate and the second substrate, the first heat sink and the second heat sink, and the chip are disposed between the first heat dissipater and the second heat dissipater. The first heat dissipater is connected to the first substrate through a third material, the second heat dissipater is connected to the second substrate through a third material, and the third material is a heat conductive interface material, including but not limited to thermal silicone grease, a graphite film, silicon gel, a phase change material, or the like. The first heat dissipater and the second heat dissipater that are disposed opposite to each other are used, so that the power module has a double-sided cooling structure, and heat can be transferred from two surfaces of the power module to the first heat dissipater and the second heat dissipater in a bidirectional manner. Compared with a single-sided cooling structure, the double-sided cooling structure has a stronger heat dissipation capability under a same process condition. This helps fully utilize performance of a power semiconductor chip, improves product power density, and reduces product costs.

Generally, the first heat dissipater and the second heat dissipater are liquid cooling heat dissipaters, a heat dissipation water channel is disposed inside both the first heat dissipater and the second heat dissipater, and the heat dissipation water channel has a water inlet and a water outlet. Coolant enters the heat dissipation water channel located inside the heat dissipater from the water inlet, absorbs heat of the heat dissipater, and finally flows out from the water outlet to take away all heat.

According to a second aspect, an embodiment of this application provides a power module manufacturing method. The method includes the following steps.

Step 1: Connect a chip to a first heat sink through sintering or welding, and connect the chip to a second heat sink through sintering or welding, to form a fast cooling unit.

Step 2: Connect a first substrate to the first heat sink through welding or sintering, perform terminal welding on the first substrate, and connect the chip to the terminal by using a binding line.

Step 3: Connect a second substrate to the second heat sink through welding or sintering, and package the foregoing structure through molding or wrapping, to form the power module.

With reference to the second aspect, in a first possible implementation, the first substrate is connected to a first heat dissipater by using a heat conductive interface material, and the second substrate is connected to a second heat dissipater by using a heat conductive interface material.

With reference to the second aspect, in a second possible implementation, when connecting is performed through sintering, a used connection material is a first material, and when connecting is performed through welding, a used material is a second material.

According to a third aspect, an embodiment of this application provides a motor driver, where the motor driver includes a capacitor and at least one power module according to embodiments of this application in the first aspect, a terminal of the power module is electrically connected to the capacitor, the capacitor is configured to provide a voltage for the power module, and the power module is configured to convert a direct current of a battery pack into an alternating current of a motor. It may be understood that the motor driver includes the power module in embodiments of this application according to the first aspect. Because the power module has good heat dissipation and better power density, power conversion efficiency of the motor driver can be improved.

According to a fourth aspect, an embodiment of this application provides a powertrain, where the powertrain includes a motor and the motor driver that is connected to the motor and that is described in embodiments of this application in the third aspect, the motor driver is configured to provide an alternating current for the motor, and the motor is configured to convert the alternating current from the motor driver into kinetic energy. It may be understood that the powertrain includes the motor driver in embodiments of this application in the third aspect. Because the motor driver has higher power conversion efficiency, higher electric energy can be provided for the motor, so that the motor can output higher kinetic energy. Therefore, the powertrain has higher driving force.

According to a fifth aspect, an embodiment of this application provides a vehicle, where the vehicle includes wheels and the powertrain that is connected to the wheel and that is described in embodiments of this application in the fourth aspect, and the powertrain is configured to provide power for the wheel, to drive the wheel to move forward or backward. It may be understood that the vehicle includes the powertrain in embodiments of this application in the fourth aspect. Because the powertrain can provide higher driving force, the vehicle has higher driving force, and better driving experience is provided for a driver.

Embodiments of this application provide a power module and a manufacturing method therefor, a motor driver, a powertrain, and a vehicle. Because the chip is placed between the first heat sink and the second heat sink that are disposed opposite to each other. The chip is connected to the first heat sink by using the first material having high heat conductivity, and the chip is connected to the second heat sink by using the second material. In this way, heat generated when the chip works can be quickly conducted, by using the first material and the second material, to the first heat sink and the second heat sink, thereby decreasing a transient temperature of the chip. In addition, because the first heat sink and the second heat sink have good temperature uniformity effect, the heat from the chip can be quickly equalized and conducted to a substrate connected to the first heat sink, and the heat is transferred to a heat dissipater through the substrate, and finally the heat is taken away by using the heat dissipater. Therefore, a steady state temperature of the chip during working is decreased, so that the chip can bear a larger current in a same size, and power density of the chip is effectively increased. Finally, because the first heat sink and the second heat sink are disposed symmetrically, thermal stress mismatch can be balanced to a maximum extent, structural stress received by the chip can be decreased. The first heat sink and the second heat sink are used as buffer protection on both sides of the chip, to prolong a working life of the component, and further improve reliability of the chip.

### BRIEF DESCRIPTION OF DRAWINGS

FIG. 1 is a diagram of a structure of a power module according to Embodiment 1 of the present invention;
FIG. 2 is a diagram of a structure of another power module according to Embodiment 2 of the present invention;
FIG. 3 is a diagram of a structure of still another power module according to Embodiment 3 of the present invention;
FIG. 4 is a power module manufacturing method according to Embodiment 4 of the present invention; and
FIG. 5 is a pressure sintering process of manufacturing a power module according to Embodiment 4 of the present invention.

### DESCRIPTION OF EMBODIMENTS

The following describes the technical solutions in embodiments of this application with reference to the accompanying drawings in embodiments of this application.

A power module plays an important role in a new energy scenario. The power module is a core component of a power conversion circuit in a new energy vehicle and smart photovoltaic. In the power conversion circuit, the power module is frequently switched between an on state and an off state in a working state, and the switching between the two states implements conversion between an alternating current voltage and a direct current voltage, to provide a proper voltage for a load. However, frequent state switching causes a heat loss of the power module, including a turn-on loss and a turn-off loss. Both of the two causes a large amount of heat to the power module, and a high temperature causes a power chip in the power module to reduce conversion efficiency or even damage. The power module is the core component of the power conversion circuit. Reduction of the conversion efficiency or even damage of the power module may severely affect an entire system, for example, the new energy vehicle cannot be started, or a smart photovoltaic system breaks down. Therefore, it has always been a research focus in the industry that heat generated by the power chip in the working state is exported out of the power module in time, to decrease the temperature of the power chip in the working state, so that the power chip can work stably for long time.

Currently, to increase a heat dissipation size and fully use two sides of a chip, a double-sided heat dissipation structure is proposed in the industry. To be specific, heat dissipaters are disposed on the two sides of the power chip, and heat of the power chip is separately exported through the two heat dissipaters. To improve stress protection for a chip and provide a path for an internal current of the chip, in a current mainstream double-sided heat dissipation structure, before a heat dissipater is installed, substrates of a structure of three layers, such as a direct bond copper (DBC), an active metal brazed copper substrate (AMB, for example, Al2O3-AMB, Si3N4-AMB, or AlN-AMB), or an insulated metal substrate (IMS), are first attached to both sides of the chip. An upper layer and a lower layer of the three layers of substrate are electrically conductive and heat conductive materials. The lower layer close to the power chip may not only provide a channel for flow of a current inside the power chip, but also may export heat generated by the power chip in time. The upper layer close to the heat dissipater may mainly provide protection for the power chip, to protect the power chip from external impact. The middle layer is an insulation layer, which can prevent the electrically conductive and heat conductive material at the lower layer from being conducted with the heat sink, and prevent a short circuit and the like of the chip.

However, because the lower layer of the substrate, for example, the DBC, is generally connected to the power chip through a copper layer, the copper layer of the lower layer is thin, and the lower layer is directly closely connected to the middle layer of the substrate, and heat dissipation performance of an insulation material, for example, ceramic, used in the middle layer of the substrate is poor. As a result, an effective heat diffusion size of the insulation material is small, and steady state heat performance is not optimal. In some current structures, to further improve heat dissipation performance, and export the heat in the power chip in time, a heat conductive column is connected to the power chip to further improve heat dissipation performance of the power module. However, because the heat conductive column is added to the power module, one side of the power chip is connected to a lower layer of the DBC, and the other side of the power chip is connected to the heat conductive column, a difference between coefficients of thermal expansion (CTE) of the two materials is large. As a result, the power chip is subject to unbalanced stress due to asymmetric thermal matching during operation, and improvement of reliability performance of the power chip is limited.

For the foregoing problem, this application provides a new power module structure and a manufacturing method therefor, a motor driver, a powertrain, and a vehicle. In this application, heat sinks with high heat conductivity and high conductivity are attached to two sides of a chip. The chip is disposed between a first heat sink and a second heat sink that are disposed opposite to each other. The chip is connected to the first heat sink by using a first material with high heat conductivity through sintering, and the chip is connected to the second heat sink by using a second material such as a common soft brazing material through welding, to construct a new fast cooling unit. Then, the fast cooling unit is disposed between the first substrate and the second substrate that are disposed opposite to each other, and the fast cooling unit is connected to the first substrate and the second substrate through welding or sintering, to finally form the new power module structure. The high heat conductive material may quickly conduct heat generated during working of the chip to a heat sink. The first heat sink and the second heat sink also have high heat conductivity, and may quickly conduct the heat from the chip, thereby decreasing a transient temperature of the chip. In addition, the first heat sink and the second heat sink have a good temperature uniformity feature, and can evenly spread heat on surfaces of the first heat sink and the second heat sink, to expand a heat dissipation size, decrease a local temperature, and improve heat dissipation efficiency. Further, the first heat sink and the second heat sink are further connected to the first substrate and the second substrate respectively, and heat dissipation sizes of the first substrate and the second substrate are greater than or equal to sizes of the first heat sink and the second heat sink. The first substrate and the second substrate further diffuse the heat from the first heat sink and the second heat sink to a larger heat dissipation size, and finally conduct the heat to a heat dissipater that is separately connected to the first substrate and the second substrate. The heat dissipater takes the heat away from the power module, thereby decreasing a temperature of the power module and decreasing a temperature of the chip in a stable working state. Therefore, the power module in this application can effectively decrease the temperature of the chip in the transient state and the steady state, so that the chip can bear a large current in a same size, thereby improving power density of the chip, and further improving performance of a motor driver, a powertrain, and a vehicle that use the power module. In addition, because the power module in this application is connected by using heat sinks on both upper and lower sides of the chip, the chip has a symmetric structure. This can balance thermal stress mismatch to a maximum extent and reduce structural stress on the chip. The first heat sink and the second heat sink are used as buffer structures to protect the two sides of the chip, to prolong a working life of the device and further improve reliability of the chip.

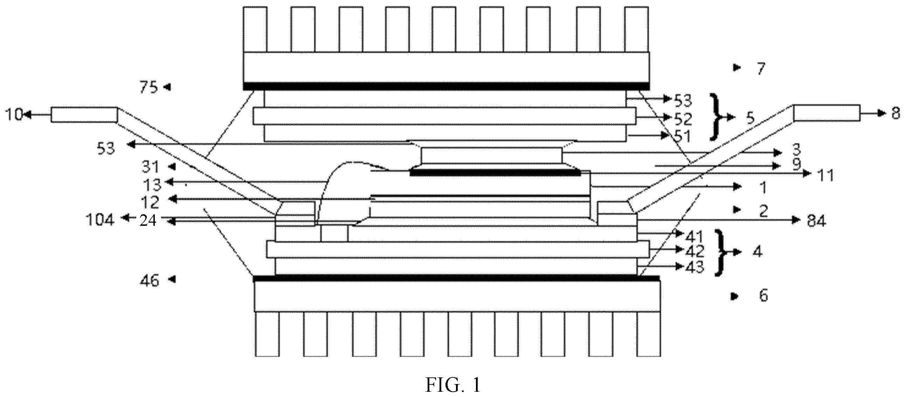

A first embodiment provided in this application is shown in FIG. 1. The first embodiment of this application provides a power module. The power module includes a chip 1, a first heat sink 2, a second heat sink 3, a first substrate 4, and a second substrate 5. The chip 1 is disposed between the first heat sink 2 and the second heat sink 3 that are placed opposite to each other, and the chip 1 is connected to the first heat sink 2 by using a first material 12 through sintering. The first material 12 has a high heat conductivity feature, and can quickly export heat generated during working of the chip 1 from the chip 1 to the first heat sink 2, to decrease a transient temperature of the chip 1. In addition, the first heat sink 2 also has a high heat conductivity feature, and can quickly export heat from the chip 1 to the first substrate 4. Finally, the first substrate 4 exports the heat out of the power module. The chip 1 is connected to the second heat sink 3 by using a second material 31 through welding. The second heat sink 3 has a high heat conductivity feature, and can quickly export the heat from the chip 1 to the second substrate 5 connected to the second heat sink 3. Finally the second substrate 5 exports the heat out of the power module. In addition, the first heat sink 2 and the second heat sink 3 have a good temperature uniformity feature, and the heat from the chip 1 can be well diffused to an entire heat sink, thereby increasing a heat dissipation size and improving heat dissipation efficiency. The first heat sink 2 is connected to the first substrate 4 by using a second material 24 through welding, and the second heat sink 3 is connected to the second substrate 5 by using a second material 53 through welding. The first substrate 4 and the second substrate 5 have larger sizes than the first heat sink 2 and the second heat sink 3, so that the heat dissipation size is further improved, thereby increasing the heat dissipation size. In addition, because the chip 1 is wrapped by using the first heat sink 2 and the second heat sink 3 in an up-down symmetric manner, thermal stress mismatch is balanced to a maximum extent, structural stress on the chip is reduced, and the chip 1 is protected from external damage. This prolongs a working life of a component and further improves reliability of the chip.

The first material 12 in Embodiment 1 has the high heat conductivity feature. For example, the high heat conductive material may be formed by silver paste, copper paste, or a silver film. During specific implementation, the silver paste may include at least one of micrometer silver paste and nanometer silver paste. The micrometer silver paste is silver paste made by using micrometer silver particles and organic solvent. The micrometer silver paste is low in costs and is safe. A general processing method includes pressure sintering, high temperature sintering, and diffusion welding. A sintering material has high density, interface of a joint body is firmly jointed, and joint reliability is high. The nanometer silver paste is silver paste made by nanometer silver particles and organic solvent. The nanometer silver paste is costly and has the safety risk of working with nanometer particles. Generally, the first material 12 has a thickness of 5 µm to 50 µm, and the first material 12 is conductive, and may provide a channel for current flow inside the chip 1.

In order to further improve the reliability of sintering, elastic modulus and a coefficient of thermal expansion (CTE) of the sintering material can be adjusted by adding a material to the sintering material. For example, the sintering material includes a main body material and a filler filled in the main body material. The main body material includes at least one of silver paste, copper paste, or a silver film. The filler is formed by a material having good performance of jointing with the main body material, and a coefficient of thermal expansion of the filler is less than a coefficient of thermal expansion of the main body material, thereby improving joint reliability of sintering.

The second material 24 in Embodiment 1 is a common welding material, and may use a high temperature solder, for example, a high-lead solder or an Au-based solder, or may use a medium temperature solder, for example, SAC305 or Sn-Sb (SnSb5, SnSb10). During specific implementation, a thickness of the solder has important impact on solder joint reliability and the like. To ensure that the thickness of the solder is controllable and the thickness is uniform, in this embodiment, a same welding material may be used when a welding manner is used. For example, a same solder may be used for a connection between the chip 1 and the second heat sink 3, a connection between the first heat sink 2 and the first substrate 4, and a connection between the second heat sink 3 and the second substrate 5. In this way, in a power module manufacturing process, the connection between the chip 1 and the second heat sink 3, the connection between the first heat sink 2 and the first substrate 4, and welding between the second heat sink 3 and the second substrate 5 may be completed through one time of reflow welding. This simplifies process steps and reduces costs.

Certainly, during specific implementation, different solders may be used for the connection between the chip 1 and the second heat sink 3, the connection between the first heat sink 2 and the first substrate 4, and the connection between the second heat sink 3 and the second substrate 5. This is not limited herein. For example, a high temperature solder may be used for the connection between the chip 1 and the second heat sink 3, for example, a High Pb solder or an Au-based solder (for example, AuSn). A medium temperature solder may be used for the connection between the first heat sink 2 and the first substrate 4 and he connection between the second heat sink 3 and the second substrate 5, for example, SAC305 or a Sn-Sb solder.

In Embodiment 1, the chip 1 may also be connected to the first heat sink 2 by using the second material 24, that is, the chip 1 may be connected to the first heat sink 2 through a common welding material through welding. Similarly, the chip 1 may also be connected to the second heat sink 3 by using the first material 12, that is, the chip 1 may be connected to the second heat sink 3 by using a high heat conductive material through sintering. Further, the chip 1 may be connected to the first heat sink 2 and the second heat sink 3 by using the first material 12, that is, the chip 1 is connected to the first heat sink 2 and the second heat sink 3 by using the high heat conductive material through sintering, or the chip 1 is connected to the first heat sink 2 and the second heat sink 3 by using the second material 24, that is, the chip 1 is connected to the first heat sink 2 and the second heat sink 3 through the common welding material described above through welding. Alternatively, the chip 1 is connected to the first heat sink 2 and the second heat sink 3 by using the first material 12 and the second material 24 that are mixed used. A specific use solution may be designed based on a specific application scenario. It should be noted that the first material 12 and the second material 24 are conductive, and may provide a channel for current flow of the chip 1 inside the power module. It may be understood that a connection manner between the chip 1, the first heat sink 2, and the second heat sink 3 is flexible and has strong applicability.

In Embodiment 1, the first heat sink 2 and the second heat sink 3 have high heat conductivity, and the first heat sink 2 and the third heat sink 3 may quickly export heat in the chip 1 to reduce the heat of the chip. Materials of the first heat sink 2 and the second heat sink 3 include but are not limited to a material having high heat conductivity, such as Cu, a CuMo composite material, diamond, a diamond-copper composite material, and an Al-SiC composite material. In addition, the first heat sink 2 and the second heat sink 3 further have an electrical conductivity feature. When the chip 1 works, a current flows inside the chip 1, and the first heat sink 2 and the second heat sink 3 may provide a current channel for the internal current of the chip 1. Therefore, the first heat sink 2 and the second heat sink 3 have the high heat conductivity feature and the high electrical conductivity feature, so that heat from the chip 1 can be exported to the chip 1 in time, heat of the chip 1 can be reduced, and a channel can be provided for flow of the current inside the chip 1. In addition, because the first heat sink 2 and the second heat sink 3 are disposed symmetrically, thermal stress mismatch can be balanced to a maximum extent, structural stress on the chip is reduced, and the chip 1 is protected from external damage. This prolongs a working life of a component and further improves reliability of the chip.

In Embodiment 1, the chip 1 is disposed in the first heat sink 2 and the second heat sink 3. When the chip works, the chip quickly switches between a turn-on state and a turn-off state, to convert an input alternating current voltage into a direct current voltage or convert an input direct current voltage into an alternating current voltage. Because the chip 1 has a turn-on loss in the turn-on state and a turn-off loss in the turn-off state, both the turn-on loss and the turn-off loss generate a large amount of heat. Therefore, the first heat sink 2 and the second heat sink 3 are required to quickly export heat in the chip 1. The chip 1 may be a power semiconductor chip, such as an insulated gate bipolar transistor (IGBT) chip, a chip packaged by an insulated gate bipolar transistor (IGBT) and a diode, a silicon metal-oxide-semiconductor field-effect transistor (MOSFET) chip, a silicon carbide (SiC) metal-oxide-semiconductor field-effect transistor (MOSFET) chip, or a gallium nitride (GaN) metal-oxide-semiconductor field-effect transistor (MOSFET) chip.

During specific implementation, the chip 1 has a first connection surface and a second connection surface, and a connection surface between the chip 1 and the second heat sink 3 is the second connection surface of the chip 1. To reduce impact of stress on the chip, the second connection surface of the chip 1 has a pad 11. The pad 11 is embedded into the chip 1, and a surface that is of the pad 11 and that is not embedded into the chip 1 is flush with the second connection surface of the chip 1. The pad 11 is connected to the second heat sink 3 by using a first material or a second material. The surface that is of the pad and that is not embedded in the chip 1 is flush with the second connection surface of the chip 1, so that the chip 1 is in full contact with the second heat sink 3, thereby expanding a heat dissipation size and improving heat dissipation efficiency, and reducing stress between the chip and the second heat sink 3. In this case, stress on the contact surface is uniform, thereby helping protect the power module from being damaged, and improving reliability of the power module.

During specific implementation, the chip 1 has the first connection surface and the second connection surface, and a connection surface between the chip 1 and the second heat sink 3 is also the first connection surface of the chip 1, that is, a heat dissipation structure of chip flipping is used.

In Embodiment 1, the chip 1, the first heat sink 2, and the second heat sink 3 form a fast cooling unit, and then the fast cooling unit is disposed between the first substrate 4 and the second substrate 5 that are disposed opposite to each other. The first substrate 4 and the second substrate 5 have a structure of three layers: an upper layer, a middle layer, and a lower layer. The upper layer and the lower layer are materials having an electrical conductivity feature and a heat conductivity feature, and the middle layer is a material having an insulation feature. Specifically, the first substrate 4 includes a first conductive layer 41, a first insulation layer 42, and a second conductive layer 43. The second substrate 5 includes a first conductive layer 51, a first insulation layer 52, and a second conductive layer 53. Generally, to achieve equivalent heat dissipation efficiency on two sides of the chip 1, increase heat balance, and reduce thermal stress mismatch, the first substrate 4 and the second substrate 5 include a same structure and material. Certainly, in some specific scenarios, a proper material may be flexibly selected based on an actual situation. This is not specifically limited in this application. In this application, an example in which the first substrate 4 and the second substrate 5 include a same structure and material is used to describe in detail an internal structure and a function of each part of the first substrate 4 and the second substrate 5. In addition, because the first substrate 4 and the second substrate 5 have a same structure and function, the first substrate 4 is used as an example for description herein.

As shown in FIG. 1, the first insulation layer 42 of the first substrate 4 is disposed between the first conductive layer 41 and the second conductive layer 43 that are disposed opposite to each other. The first conductive layer is connected to the first heat sink 2 by using a first material or a second material. The first conductive layer 41 in the first substrate 4 is electrically conductive, and may provide a channel for flow of a current inside the chip 1. In addition, the first conductive layer is also thermally conductive, and can export heat from the chip 1 in time. Therefore, a material of the first conductive layer 41 may be a material such as Cu or Al. A specific material to be used may be selected according to an actual situation, and is not limited herein. The first insulation layer 42 in the first substrate 4 is insulated. Because the current in the chip 1 flows in the first conductive layer 41 in the first substrate 4, and the second conductive layer 43 is connected to a heat dissipater 7, the heat dissipater 7 generally uses a cooling liquid to export heat in the power module to the outside. Therefore, the heat dissipater 7 is located in a damp environment. If the current in the first conductive layer 41 finally flows to the heat dissipater 7 through the second conductive layer 43, a problem such as a short circuit of the chip 1 is caused. Therefore, the first insulation layer 42 needs to perform insulation isolation between the first conductive layer 41 and the second conductive layer 43, to prevent the current in the chip 1 from entering the heat dissipater 7. The second conductive layer 43 in the first substrate 4 is connected to the heat dissipater 7 through a third material 47. The third material 47 may be a heat conductive interface material. The second conductive layer 43 is configured to protect the first insulation layer 42 in the first substrate 4 to prevent the first insulation layer 42 from breaking. The second conductive layer 43 has a heat conduction function, and conducts heat from the first insulation layer 42 to the heat dissipater 7 that is in contact with the second conductive layer 43, so that the heat is finally taken away by the coolant in the heat dissipater 7. A material of the second conductive layer 43 may be a material such as Cu or Al.

Generally, the first substrate 4 and the second substrate 5 may be a direct bond copper (DBC), an active metal brazed copper substrate (AMB, for example, Al2O3-AMB, Si3N4-AMB, or AlN-AMB), an insulated metal substrate (IMS), or the like. This is not limited herein. For example, to further improve power density, the first substrate and the second substrate may be formed by using AlN-DBC, Si3N4-AMB, or AlN-AMB with high heat conductivity. This is not limited herein.

The power module in Embodiment 1 further includes a first terminal 8 and a second terminal 10. One end of the first terminal 8 is connected to the first substrate 4 by using the second material 84 through welding, and the other end of the first terminal 8 is connected to an external circuit of the power module. One end of the second terminal 10 is connected to the second substrate 5 by using a second material 105 through welding, and the other end of the second terminal 10 is connected to an external circuit of the power module. Materials and processes of the first terminal 8 and the second terminal 10 are not limited herein. Materials and processes used for connecting the first terminal 8 to the first substrate 4 and connecting the second terminal 10 to the second substrate 5 are not specifically limited. The first material may be connected through sintering, or the second material may be connected through welding, or the two manners may be flexibly adapted according to a specific scenario.

The power module in Embodiment 1 further includes a binding line 13. The binding line 13 is configured to connect the chip 1 to the second terminal 10. The binding line 13 is a conducting wire, so that the chip 1 may interact with an external signal through the second terminal 10. One end of the binding line 13 is electrically connected to the chip 1 through bonding, and the other end of the binding line 13 is electrically connected to the first substrate 4 through bonding. Specifically, the binding line 13 is electrically connected to a pad on the first substrate 4 through bonding, and the second terminal 10 is also connected to the pad, so that the second terminal 10 can be connected to the chip 1. The bonding manner in Embodiment 1 is an existing manner of connecting a metal wire to a pad, and specifically, the metal wire is tightly bonded to the pad through heat, pressure, or ultrasonic energy. Certainly, in some other examples, the two ends of the binding line 13 may also be electrically connected to the pad and the chip 1 in another manner, for example, connected through conductive adhesive or fusion.

In Embodiment 1, after the power module completes internal interconnection, a molding body 9 is further required to perform molding. The molding body 9 wraps the first heat sink 2, the second heat sink 3, the chip 1, the first substrate 4, the second substrate 5, the binding line 13, and the terminal 11 located inside the power module, to form a power semiconductor package. This provides a closed environment for the entire power module, and prevents external water or liquid from entering the power module, and prevents a short circuit of the chip. In addition, the molding body fastens each part of the power module, thereby improving stability between the parts of the power module.

A molding compound used by the molding body 9 is a low modulus molding compound, which can improve reliability of the power module. The molding compound may include a material whose elastic modulus is between 0.5 GPa and 20 GPa, for example, an epoxy molding compound. This is not limited herein. During specific implementation, after molding is completed, upper and lower surfaces of the power module may be ground, so that two surfaces of the power module are parallel. Certainly, the surfaces may also be unnecessary to grind according to a requirement. For example, after molding, tin plating processing may be further performed on the terminal 11 exposed outside the power module, to prevent the terminal from being oxidized and increase solderability of the terminal. In addition, at least a part of an area that is of the molding body 11 and that is opposite to at least one of the first substrate 4 and the second substrate 5 is an exposed area. In this way, blocking of a molding layer is eliminated, and the first substrate 4 is in closer contact with the second substrate 5 and the heat dissipater, thereby facilitating heat transfer.

In Embodiment 1, the power module further includes a first heat dissipater 6 and a second heat dissipater 7. The first heat dissipater 6 and the second heat dissipater 7 may finally export heat generated by the chip 1. After molding is performed on the power module to form the power semiconductor package, the first heat dissipater 6 and the second heat dissipater 7 need to be connected to the power module. The first heat dissipater 6 is disposed opposite to the heat dissipater. The first heat dissipater 6 is connected to the first substrate 4 through the third material 46. The second heat dissipater 7 is connected to the second substrate 5 through the third material 75. The third material 46 includes but is not limited to a heat conductive interface material such as thermal silicone, a graphite film, silicon gel, or a phase change material. Materials selected for the third material 46 and the third material 75 may be the same or may be different. This is not limited herein. Generally, the first heat dissipater 6 and the second heat dissipater 7 have heat dissipation fins, and the heat dissipation fins may increase a heat dissipation size, thereby improving heat dissipation efficiency of the heat dissipater. In Embodiment 1, the first heat dissipater 6 and the second heat dissipater 7 that are disposed opposite to each other are used, so that the power module has a double-sided cooling structure. Heat may be exported from two surfaces of the power module. Compared with a single-sided cooling structure in which only one heat dissipater is used, heat dissipation efficiency of the power module can be improved, and heat dissipation efficiency of the power module can be further improved. In addition, a double-sided symmetric structure may also minimize thermal stress imbalance to a maximum extent, reduce a risk of damage to the power module, and improve reliability of the power module.

Generally, the first heat dissipater 6 and the second heat dissipater 7 are liquid cooling heat dissipaters, a heat dissipation water channel is disposed inside both the first heat dissipater 6 and the second heat dissipater 7, and the heat dissipation water channel has a water inlet and a water outlet. Coolant enters the heat dissipation water channel located inside the heat dissipater from the water inlet, absorbs heat of the heat dissipater, and finally flows out from the water outlet to take away all heat. The coolant may also be oil coolant, and has more advantages than conventional coolant (water). The oil coolant has a sensitive heat balance capability and an optimal heat conduction capability. This ensures that the chip 1 is in an optimal operating temperature. The oil coolant has a wide operating temperature range, and no antifreeze needs to be added in a low temperature environment. This avoids corrosion damage such as gas corrosion, water scale, and electrolysis, and is well compatible with a rubber tube. A specific type of the coolant is not limited herein, and proper coolant may be selected in a more specific scenario and an actual situation. It should be noted that, in some scenarios, to facilitate a connection between the first heat dissipater 6 and the second heat dissipater 7 through a connecting piece, coolant in the first heat dissipater 6 may enter the second heat dissipater 7 through the connecting piece, thereby improving utilization of the coolant.

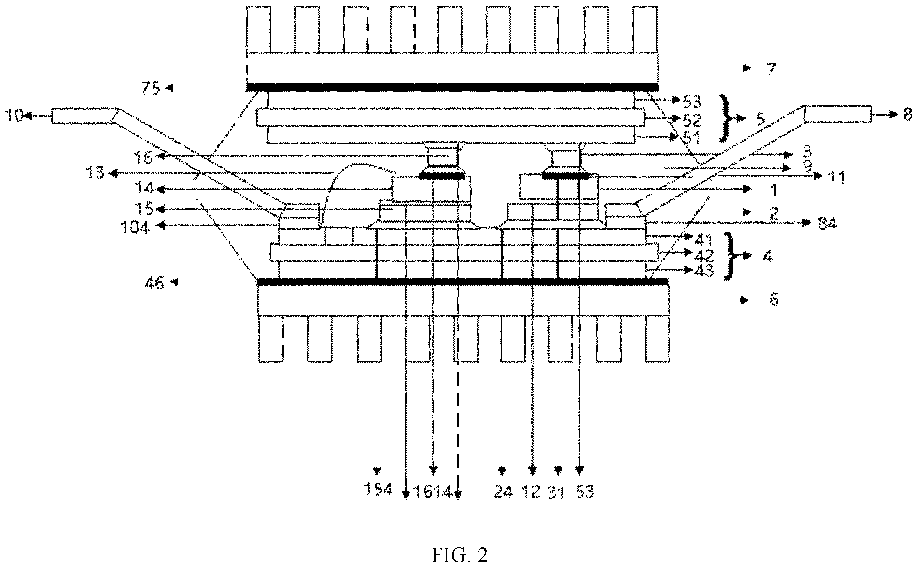

A second implementation of this application provides another power module. As shown in FIG. 2, the power module includes two independent chips: a first chip 1 and a second chip 14. The first chip 1 is disposed between a first heat sink 2 and a second heat sink 3 that are disposed opposite to each other, and the second chip 14 is disposed between a third heat sink 15 and a fourth heat sink 16 that are disposed opposite to each other. Materials used by the first heat sink 2, the second heat sink 3, the third heat sink 15, and the fourth heat sink 16 are the same as those in the first embodiment of this application. Connections between the first chip 1, the first heat sink 2, and the second heat sink 3 are the same as those in the first embodiment of this application. Connections between the second chip 14 and the third heat sink 15 and the fourth heat sink 16 are the same as those in the first embodiment of this application. An independent cooling structure is disposed for the two independent chips 1 and 14, and a proper heat sink material and a connection manner may be disposed according to different features of the two chips. The manner is flexible and adaptable. In other parts of the second implementation, a connection of other parts, such as a first substrate 4, a second substrate 5, a molding body 9, a first terminal 8, a second terminal 10, a binding line 13, a first heat dissipater 6, and a second heat dissipater 7, are consistent with those in Embodiment 1 of this application. Therefore, details are not described herein again. Generally, the power module in embodiments of this application may further include a plurality of chips, and a quantity of chips is greater than two. A quantity of chips in the power module is not limited in embodiments of this application.

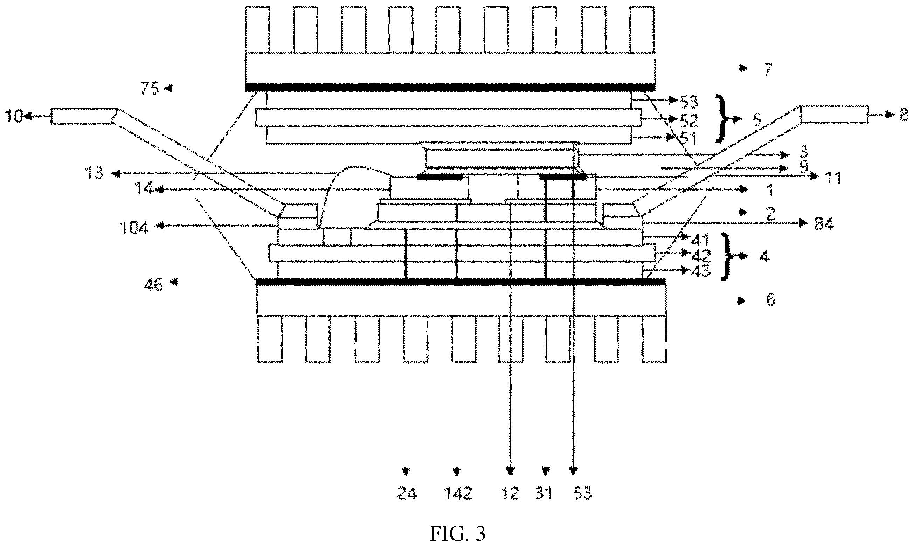

A third implementation of this application provides another power module. As shown in FIG. 3, the power module includes two independent chips: a first chip 1 and a second chip 14. The first chip 1 and the chip 14 are jointly disposed between a same first heat sink 2 and a same second heat sink 3 that are disposed opposite to each other. Materials used by the first heat sink 2 and the second heat sink 3 are the same as those in the first embodiment of this application. Connections between the first chip 1 and the second chip 14, and between the first heat sink 2 and the second heat sink 3 are the same as those in the first embodiment of this application. A same cooling structure is disposed for the two independent chips 1 and 14. This can reduce process complexity, improve efficiency, and reduce manufacturing costs. It should be noted that in other parts of the third implementation, a connection of other parts, such as a first substrate 4, a second substrate 5, a molding body 9, a first terminal 8, a second terminal 10, a binding line 13, a first heat dissipater 6, and a second heat dissipater 7, are consistent with those in Embodiment 1 of this application. Therefore, details are not described herein again. Generally, the power module in embodiments of this application may further include a plurality of chips, and a quantity of chips is greater than two. A quantity of chips in the power module is not limited in embodiments of this application.

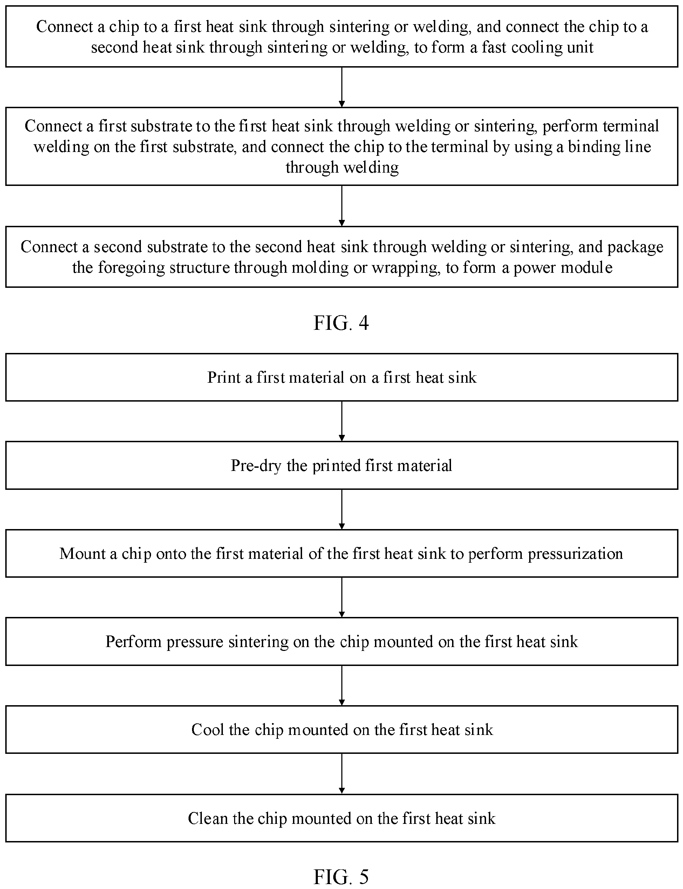

A fourth implementation of this application provides a power module manufacturing method. As shown in FIG. 4, the method includes the following steps.

S1: Connect a chip to a first heat sink through sintering or welding, and connect the chip to a second heat sink through sintering or welding, to form a fast cooling unit.

S2: Connect a first substrate to the first heat sink through welding or sintering, perform terminal welding on the first substrate, and connect the chip to the terminal by using a binding line through welding.

S3: Connect a second substrate to the second heat sink through welding or sintering, and package the foregoing structure through molding or wrapping, to form the power module.

The power module manufacturing method in Embodiment 4 further includes: connecting the first substrate to a first heat dissipater by using a heat conductive interface material, and connecting the second substrate to a second heat dissipater by using a heat conductive interface material.

In the power module manufacturing method in Embodiment 4, when connecting is performed through sintering, a used connection material is a first material; when connecting is performed through welding, a used connection material is a second material.

In Embodiment 4, connecting through sintering may be pressure sintering. For steps of pressure sintering, a connection between the chip and the first heat sink is used as an example for description, as shown in FIG. 5.

S11: Print a first material on the first heat sink. A sintering material may be printed on the first heat sink by using a stencil printing process or a screen printing process. Compared with the screen printing process, the stencil printing process is low in costs and simple in production. A thickness of the first material may be controlled to be between 30 µm and 160 µm, and may be specifically designed according to an actual product. This is not limited herein.

S12: Pre-dry the printed first material. The pre-drying the printed first material is to prevent the sintering material from being crushed during pressure sintering. Generally, the first material 13 printed on the first heat sink may be dried for 5 min to 40 min at a temperature of 100°C to 180°C in an atmosphere of N2.

S13: Mount the chip onto the first material of the first heat sink to perform pressurization. The chip may be first sucked up through vacuum adsorption, then the first heat sink is aligned by using a profile identification system, and then the chip is fastened on the dried first material for pressurization. Generally, the temperature is controlled to be between100°C and 180°C, the pressure is controlled to be between 0.1 MPa and 10 MPa, and the time is controlled to be between 10 ms and 999 ms.

S14: Perform pressure sintering on the chip mounted on the first heat sink. Pressure sintering is to apply pressure to a joint body at a high temperature, thereby increasing density of the jointed body, promoting atomic diffusion between particles of the sintering material and between the sintering material and the joint body, and enhancing joint strength and joint reliability. A used pressure sintering process is not limited in this application, and may be any well-known method. Generally, a sintering condition for pressure sintering is as follows: A sintering temperature is controlled to be between 200°C and 300°C, applied pressure is controlled to be between 5 MPa and 30 MPa, and sintering time is controlled to be between 1 min and 10 min.

S15: Cool, in a pressurized state, the first heat sink and the chip that are sintered. If the pressure sintering process is performed in a protective atmosphere or a vacuum environment, the cooling process is also performed in a protective atmosphere or a vacuum environment. Generally, a cooling condition may be as follows: Applied pressure is controlled to be between 5 MPa and 20 MPa, and cooling time is controlled to be between 1 min and 10 min.

S16: Clean the first heat sink on which the chip is mounted, to remove residual organic matter. For example, a plasma treatment process or an organic solvent cleaning process is used to remove the residual organic matter at the first heat sink or the like, to improve interface joint of a subsequent molding compound, prevent the molding compound from being layered, and further improve reliability of the power module.

The power module manufactured by using the manufacturing method in Embodiment 4 has the same advantages as the power modules in all the foregoing embodiments, and details are not described again. Materials used by the parts used in Embodiment 4 including the chip, the first heat sink, the second heat sink, the first substrate, the second substrate, the first material, the second material, the third material, the first heat dissipater, the second heat dissipater, the molding body, and the terminal are the same as those used by the power module in all the foregoing embodiments, and details are not described again.

A fifth implementation of this application provides a motor driver. The motor driver includes a capacitor and at least one power module according to any one of the foregoing embodiments of this application, a terminal of the power module is electrically connected to the capacitor, the capacitor is configured to provide a voltage for the power module, and the motor driver is configured to convert a direct current of a battery pack into an alternating current of a motor. In embodiments of this application, for a structure and a working principle of the power semiconductor module, refer to the description in the foregoing embodiment. Details are not described again in embodiments of this application.

Generally, in the motor driver provided in embodiments of this application, because the motor driver includes the power module in any one of the foregoing embodiments of this application, and the power module uses a double-sided symmetric new cooling structure, heat dissipation performance of the power module is greatly improved. Therefore, for a power chip with a same size, the power chip of the power module in embodiments of this application can bear a higher current, to obtain higher power density. Therefore, the motor driver of the power module can output higher power, and higher power conversion efficiency can be achieved. In addition, because the power module in embodiments of this application can balance thermal stress mismatch to a maximum extent, and reduce structural stress on the chip, the chip in the power module has high reliability and a long working life. Therefore, the motor driver of the power module in any one of the foregoing embodiments of this application is used, and the motor driver has high reliability and can work stably for a long time.

A sixth implementation of this application provides a powertrain. The powertrain includes a motor and the motor driver that is connected to the motor and that is described in the fifth embodiment of this application, the motor driver is configured to provide an alternating current for the motor, and the motor is configured to convert the alternating current from the motor driver into kinetic energy. For a structure and a working principle of the power module in the motor driver, refer to the description in the foregoing embodiment. Details are not described again in embodiments of this application.

Generally, the powertrain provided in embodiments of this application includes the motor driver in the fifth embodiment of this application. Because the motor driver has higher power conversion efficiency, higher electric energy can be provided for the motor, so that the motor can output higher kinetic energy. Therefore, the powertrain has higher driving force. In addition, because the motor driver is not easily damaged and has high reliability, stability and reliability of the powertrain system are improved.

A seventh implementation of this application provides a vehicle, where the vehicle includes wheels and the powertrain that is connected to the wheel and that is described in the sixth embodiment of this application, and the powertrain is configured to provide power for the wheel, to drive the wheel to move forward or backward. In embodiments of this application, the vehicle may be an electrocar/an electric vehicle (EV), a pure electric vehicle/battery electric vehicle (PEV/BEV), a hybrid electric vehicle (HEV), a range extended electric vehicle (REEV), a plug-in hybrid electric vehicle (PHEV), a new energy vehicle, or the like. For a structure and a working principle of the power module in the powertrain, refer to the description in the foregoing embodiment. Details are not described again in embodiments of this application.

Generally, the vehicle includes the powertrain in the sixth embodiment of this application. Because the powertrain can provide higher driving force, the vehicle has higher driving force, and better driving experience is provided for a driver. In addition, because the powertrain has higher stability and reliability, the vehicle has higher stability and reliability as a whole, thereby providing higher safety for the driver and reducing maintenance costs of the entire vehicle.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A power module, comprising a first substrate, a second substrate, a first heat sink, a second heat sink, and a chip, wherein
the chip is disposed between the first heat sink and the second heat sink, and a connection surface between the chip and the first heat sink is a first connection surface of the chip;
the chip is connected to the first heat sink by using a first material, the first material has high heat conductivity, the first material comprises one of silver paste, copper paste, and a silver film, and the first material connects the chip to the first heat sink through high temperature sintering or diffusion welding; and
the first substrate is disposed on a surface that is of the first heat sink and that is away from the chip, and the second substrate is disposed on a surface that is of the second heat sink and that is away from the chip.

2. The power module according to claim 1, wherein the connection surface between the chip and the first heat sink is the first connection surface of the chip, and a size of a surface that is of the first heat sink and that is close to the chip is greater than or equal to a size of the first connection surface of the chip.

3. The power module according to claim 1, wherein the chip is disposed between the first heat sink and the second heat sink, and a connection surface between the chip and the second heat sink is a second connection surface of the chip; and
the chip is connected to the second heat sink by using a second material, the second material is a soft brazing material, the first material comprises one of Sn3.5Ag 0.5Cu, SnSb5, SnSb10, High Pb, and AuSn, and the second material connects the chip to the first heat sink through welding.

4. The power module according to any one of claims 1 to 3, wherein the chip is connected to the first heat sink by using the second material, and the chip is connected to the second heat sink by using the first material; and
connections of the chip to the first heat sink and the second heat sink both can use the first material or the second material.

5. The power module according to claim 1, comprising the first heat sink and the second heat sink, wherein both the first heat sink and the second heat sink have a high heat conductivity feature and a high electrical conductivity feature, and materials of the first heat sink and the second heat sink comprise one of materials having high heat conductivity, such as Cu, a CuMo composite material, diamond, a diamond-copper composite material, and an Al-SiC composite material.

6. The power module according to claim 1, comprising the first substrate and the second substrate, wherein the first substrate and the second substrate comprise a first conductive layer, a second conductive layer, and a first insulation layer located between the first conductive layer and the second conductive layer;
materials of the first conductive layer and the second conductive layer are Cu, Al, or other materials that are electrically and thermally conductive; and
the first insulation layer is of ceramic or another insulating material.

7. The power module according to claim 1 or 6, wherein that the first substrate is disposed on a surface that is of the first heat sink and that is away from the chip, and the second substrate is disposed on a surface that is of the second heat sink and that is away from the chip comprises:
the first substrate is connected to the first heat sink by using the second material, and the second substrate is connected to the second heat sink by using the second material; or
the first substrate is connected to the first heat sink by using the first material, and the second substrate is connected to the second heat sink by using the first material.

8. The power module according to any one of claims 1 to 4, wherein the connection surface between the chip and the second heat sink is the second connection surface of the chip, the back connection surface of the chip has a pad, the pad is embedded into the chip, and a surface that is of the pad and that is not embedded into the chip is flush with the second connection surface of the chip; and
the pad is connected to the second heat sink by using the first material or the second material.

9. The power module according to any one of claims 1 to 4 or claim 8, wherein the chip comprises one of an insulated gate bipolar transistor chip, an insulated gate bipolar transistor chip and a diode chip packaged chip, a silicon metal-oxide-semiconductor field-effect transistor, a silicon carbide metal-oxide-semiconductor field-effect transistor, or a gallium nitride metal-oxide-semiconductor field-effect transistor.

10. The power module according to any one of claims 1 to 4 or claim 8 and 9, wherein the chip comprises at least two independent chips, and the at least two independent chips are disposed between the first heat sink and the second heat sink; or
the at least two independent chips are respectively disposed between first heat sinks and second heat sinks corresponding to the at least two independent chips, the first heat sinks corresponding to the at least two independent chips are independent of each other and are not directly connected to each other, and the second heat sinks corresponding to the at least two independent chips are independent of each other and are not connected to each other.

11. The power module according to any one of claims 1 to 10, wherein the power module further comprises a terminal, one end of the terminal is electrically connected to the chip, the other end of the terminal is located outside the power module, and the terminal is configured to connect the chip in the power module to an external circuit.

12. The power module according to any one of claims 1 to 11, wherein the power module further comprises a binding line, one end of the binding line is electrically connected to the chip, and the other end of the binding line is electrically connected to the terminal.

13. The power module according to any one of claims 1 to 12, wherein the power module further comprises a first heat dissipater and a second heat dissipater, the first heat dissipater and the second heat dissipater are disposed opposite to each other, and the first substrate and the second substrate, the first heat sink and the second heat sink, and the chip are disposed between the first heat dissipater and the second heat dissipater; and
the first heat dissipater is connected to the first substrate by using a heat conductive interface material, the second heat dissipater is connected to the second substrate by using a heat conductive interface material, and the heat conductive interface material comprises one of thermal silicone grease, a graphite film, silicon gel, and a phase change material.

14. The power module according to any one of claims 1 to 13, wherein the power module further comprises a molding body, and the molding body wraps the first substrate, the second substrate, the first heat sink, the second heat sink, and the chip together, to seal the first substrate, the second substrate, the first heat sink, the second heat sink, and the chip.

15. A power module manufacturing method, wherein the method comprises:
connecting a chip to a first heat sink through sintering or welding, and connecting the chip to a second heat sink through sintering or welding, to form a fast cooling unit;
connecting a first substrate to the first heat sink through welding or sintering, performing terminal welding on the first substrate, and connecting the chip to the terminal by using a binding line; and
connecting a second substrate to the second heat sink through welding or sintering, and packaging the structure through molding or wrapping, to form the power module.

16. The manufacturing method according to claim 15, wherein the method further comprises:
connecting the first substrate to a first heat dissipater by using a heat conductive interface material, and connecting the second substrate to a second heat dissipater by using a heat conductive interface material.

17. The manufacturing method according to claim 15 or 16, wherein the method further comprises:
when connecting is performed through sintering, a used connection material is a first material, and when connecting is performed through welding, a used material is a second material.

18. A motor driver, comprising a capacitor and at least one power module according to any one of claims 1 to 14, wherein a terminal of the power module is electrically connected to the capacitor, the capacitor is configured to provide a voltage for the power module, and the power module is configured to convert a direct current of a battery pack into an alternating current of a motor.

19. A powertrain, comprising a motor and the motor driver according to claim 18 connected to the motor, wherein the motor driver is configured to provide electric energy for the motor, and the motor is configured to convert an alternating current from the motor driver into kinetic energy.

20. A vehicle, comprising wheels and the powertrain according to claim 19 connected to the wheel, wherein the powertrain is configured to provide power for the wheel and drive the wheel to move forward or backward.
